**Europäisches Patentamt**

**European Patent Office**

(19) **Office européen des brevets**

(11) Veröffentlichungsnummer: **0 172 498**
**B1**

(12) **EUROPÄISCHE PATENTSCHRIFT**

(45) Veröffentlichungstag der Patentschrift:
**22.06.88**

(51) Int. Cl.⁴: **G 01 R 1/06**, G 01 R 29/24,
G 01 R 5/28

(21) Anmeldenummer: **85109962.2**

(22) Anmeldetag: **04.02.82**

(60) Veröffentlichungsnummer der früheren Anmeldung
nach Art. 76 EPÜ: **0070846**

(54) **Elektrode zum Abgreifen einer Spannung einer Quelle mit flächenhaftem Abgriff.**

(30) Priorität: **05.02.81 DE 3103887**

(43) Veröffentlichungstag der Anmeldung:
**26.02.86 Patentblatt 86/9**

(45) Bekanntmachung des Hinweises auf die Patenterteilung:
**22.06.88 Patentblatt 88/25**

(84) Benannte Vertragsstaaten:
**AT BE CH DE FR GB LI LU NL SE**

(56) Entgegenhaltungen:
**APPLIED PHYSICS LETTERS, Band 26, Nr. 7, 1. April
1975, Seiten 400-402, American Institute of Physics, US;
K. ZIEGLER et al.: "Static technique for precise
measurements of surface potential and interface state
density in MOS structures"
ELEKTRONIK, Heft 4, 1975, Seiten 79-83; K. CAMMANN:
"Hinweise zur elektronischen pH- und
Ionenmesstechnik"**

(73) Patentinhaber: **TROESCH, Jacques J.,
Walchestrasse 19, CH-8035 Zürich (CH)**

(72) Erfinder: **TROESCH, Jacques J., Walchestrasse 19,
CH-8035 Zürich (CH)**

(74) Vertreter: **Troesch, Hans Alfred, Dr. Ing. et al,
Walchestrasse 19, CH-8035 Zürich (CH)**

ACTORUM AG

## Beschreibung

Die vorliegende Erfindung betrifft eine Elektrode zum Abgreifen einer Spannung einer Quelle mit flächenhaftem Abgriff.

Es haldelt sich um eine Teilanmeldung der Europäischen Anmeldung No. 82900340.9, die der EP-A-0 070 846 (veröffentlicht am 09. 02. 1983) entspricht, hervorgegangen aus der PCT-Anmeldung No. CH82/00017 des selben Anmelders. In der erwähnten Stammanmeldung ist ein serie-parallel gegengekoppelter Messkreis zum Messen einer elektrischen Spannung beschrieben und beansprucht, bei dem die zu messende Spannung in Serie mit einer ihr gegenwirkende Ausgangsspannung des Messkreises auf einen Eingang eines Verstärkers wirkt und dabei die Ausgangsspannung als Messignal abgegriffen wird, bei dem weiter der Verstärker zur Messung eines durch die Differenz aus zu messender Spannung und Ausgangsspannung getriebenen Stromes als parallel gegengekoppelter Stromverstärker ausgebildet ist, und bei dem die Ausgangsspannung in Serie mit der zu messenden Spannung über ein zugeschaltetes kapazitives Impedanzelement auf den Eingang des Stromverstärkers geschaltet ist.

Dieser serie-parallel gegengekoppelte Messkreis ist nicht Gegenstand der vorliegenden Teilanmeldung, hingegen eignet er sich vorzüglich für den messtechnischen Einsatz der hier beschriebenen und beanspruchten Elektrode. Die Kombination der hier für sich beanspruchten und beschriebenen Elektrode mit dem erwähnten Messkreis ist in der obgenannten Stammanmeldung angegeben. Da es für das Verständnis einer Einsatzmöglichkeit der hier vorliegenden Erfindung wesentlich ist, als Beispiel den in der Stammanmeldung beschriebenen Messkreis mit zu beschreiben, wird dies hier auch vorgenommen, wobei ausdrücklich auf die oben erwähnte Stammanmeldung, worin dieser Messkreis beschrieben ist, Bezug genommen wird.

Spannungsquellen herkömmlicher Art weisen zwei metallische Abgriffe auf, zwischen welchen die Spannung abgegriffen werden kann. Jedes Punktepaar, das auf verschiedenen elektrischen Potentialen liegt, kann als Abgriffspaar einer Spannungsquelle bezeichnet werden. Bei vielen in der Natur vorkommenden derartigen Spannungsquellen besteht für deren Messung das Problem darin, dass die Quellenabgriffe aus x-beliebigen Materialphasen bestehen, somit entweder die Quelleninnenimpedanz extrem hochohmig ist und/oder durch Vorsehen eines messkreisseitigen metallischen Abgriffes an die eine der Materialphasen, eine sich dem zu messenden Signal überlagernde störende Spannungsquelle einstellt.

Aus Elektronik, Heft 4, 1975, S. 79–83 von K. Cammann: «Hinweise zur elektronischen pH- und Ionenmesstechnik» ist die Problematik bezüglich der Anfroderungen an die Hochohmigkeit eines Spannungsmesskreises zur Spannungsmessung mittels Elektroden mit hohem Grenzflächenwiderstand bwz. kleinen Austauschstromdichten im Zusammenhang mit direkt-potentiometrischen Messungen bekannt. Wegen des deshalb bei hochohmigen Elektroden zu treibenden Aufwandes wird ein Einsatz von Elektroden mit höheren Austauschstromdichten, d. h. niederohmigeren Elektroden, angestrebt. Bei solchen Elektroden findet man aber, nach ihrer Applikation, mehr oder minder ausgesprochenes Einschwingverhalten, bis sich an der Grenzfläche zu einer mittels solcher Elektroden abgegriffenen Phase, elektrochemisches Gleichgewicht einstellt. Dies führt unmittelbar nach Applikation derartiger Elektroden zu zeitlich variablen Messspannungen. Messungen werden erst nach Abklingen solcher transienter Vorgänge repräsentativ.

Die vorliegende Erfindung setzt sich zum Ziel, eine Elektrode eingangs genannter Art zu schaffen, die ein Abgreifen von Spannungsquellen mit flächenhaftem Abgriff weitgehendst beliebiger Materialphasen ermöglicht und bei der verringerte Störspannungen durch die Messquellen-Kontaktierung entstehen.

Dies wird dadurch erreicht, dass die Elektrode aus einer Isolationsschicht besteht, die auf einer Seite eine Leiterschicht mit elektrischem Abgriff aufweist, derart, dass bei Anlegen der freien Schichtseite an den flächenhaften Abgriff der Quelle, durch letzteren, die Isolationsschicht und die Leiterschicht eine zur Quelle seriegeschaltete Kapazität entsteht.

Bei Anlegen einer derartigen Elektrode an den einen Abgriff einer beliebigen Spannungsquelle wird somit die erwähnte Kapazität mit letzterer seriegeschaltet.

Insbesondere bei der Anwendung dieser Elektrode zur Messung von DC- oder sich langsam ändernden Spannungssignalen wird durch die Elektrode eine mit der Innenimpedanz der Quelle seriegeschaltete, analog wirkende Kapazität der «idealen» Quelle als Anteil der «realen» zugeschaltet. Deshalb muss in ihrer Anwendung ein extrem hochohmiger Messkreis eingesetzt werden, wie er in der EP-A-0 070 846 beschrieben ist, wobei dann die erfindungsgemässe Elektrode die obgenannten Vorteile mit sich bringt, wobei gefunden wurde, dass bezüglich manchen, wie beispielsweise ionenleitenden, Materialphasen die erwähnte Isolationsschicht elektrochemisch relativ inaktiv gewählt werden kann, womit sich die durch den Abgriff bedingte Störspannung reduziert.

In der Anwendung der Elektrode zur Messung einer Kontaktspannung zwischen Isolatoren wird das elektrochemische Verhalten der sich kontaktierenden Isolatoren verfolgt.

In der Anwendung der Elektrode als Bezugselektrode in einer elektrochemischen Zelle mit einer ersten Materialphase und einer zweiten, wobei die Spannung zwischen der ersten und zweiten Materialphase, der ersten Halbzelle, zu messen ist und die Isolationsschicht mit der einen der Phasen, als zweite Halbzelle, in Kontakt steht, wird ausgenützt, dass, mit einer bezüglich der genannten einen Phase elektrochemisch relativ inaktiven Isolationsschicht das Spannungssignal zwischen der ersten und zweiten Materialphase bei der Messung nur wenig durch dasjenige zwischen der einen Phase und der Isolationsschicht gestört wird.

Die Erfindung wird anschliessend beispielsweise anhand von Figuren erläutert.

Es zeigen:

Fig. 1 die Anordnung eines Messkreises zur Spannungsmessung, wie in der EP-A-0 070 846 beschrieben und beansprucht,

Fig. 2 eine bevorzugte Anordnung des Kreises gemäss Fig. 1,

Fig. 3a eine erfindungsgemässe Elektrode, im Einsatz an einer Metall-Elektrolytlösungs-Halbzelle mit dem Ersatzbild der Gesamtzelle,

Fig. 3b zwei erfindungsgemässe Elektroden mit unterschiedlichen Isolationsschichten zur Messung, entweder der Kontaktspannung zwischen den Isolationsschichtmaterialien oder der Differenz der Kontaktspannungen je von einer Isolationsschicht zu einer dazwischenliegenden Elektrolytlösung.

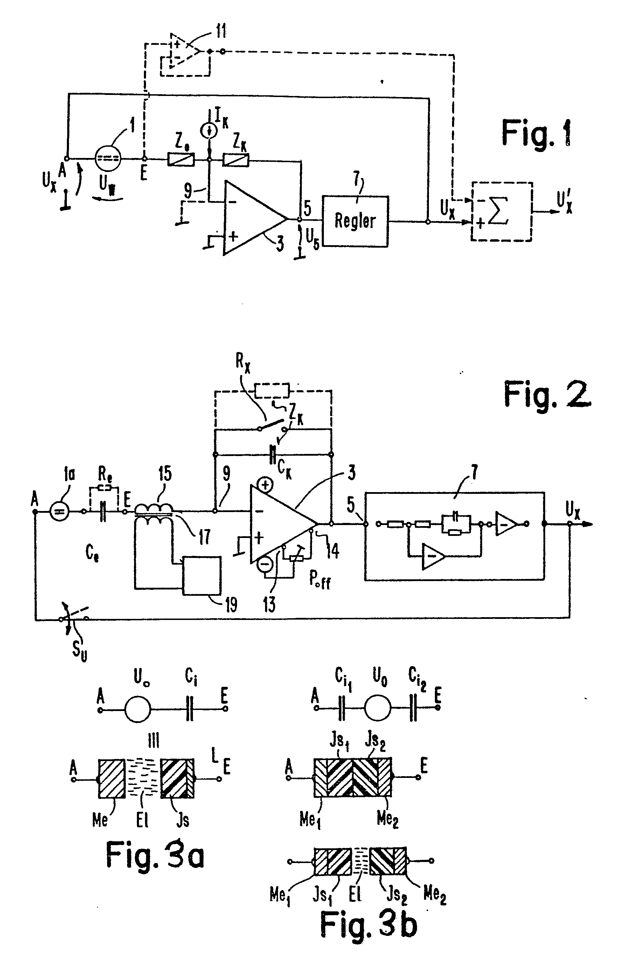

In Fig. 1 ist der Aufbau eines Messkreises gemäss EP-A-0 070 846 für den Einsatz mit einer noch zu beschreibenden Elektrode dargestellt. Eine Spannungsquelle 1 ist mit einem Anschluss mit dem Eingang E eines mit den Impedanzen $Z_e$ und $Z_K$ invertierend beschalteten Operationsverstärkers 3 verbunden. Der Ausgang 5 des Operationsverstärkers ist über einen Regler 7 auf den zweiten Anschluss der Spannungsquelle 1,A rückgeführt. Bei Aufschalten der eigentlich als Führungsgrösse wirkenden Spannung $U_w$ der Quelle 1 fliesst wegen des niederohmigen Rückführungsanschlusses an A und dem virtuell auf Masse geschalteten Stromsummationspunkt 9 des Operationsverstärkers 3 kurzzeitig ein Strom durch die Eingangsimpedan $Z_e$ des Operationsverstärkers 3, von dort auf die Rückkopplungsimpedanz $Z_K$, so dass die Ausgangsspannung $U_5$, über den Regler 7 als Regelgrösse $U_x$ auf den Anschluss A rückgeführt, die an E anliegende Gesamtspannung rasch zu Null werden lässt.

Der Frequenzgang des Reglers 7 wird nach Massgabe der Übertragungsfunktion des Operationsverstärkers 3 mit dem Gegenkopplungs-Netzwerk $Z_e$, $Z_K$ so gewählt, dass der offene Regelkreis, vorzugsweise PI- oder PID-Verhalten zeigt.

Es kann gezeigt werden, dass bei grosser Verstärkung des offenen Regelkreises ein Störstrom am Stromsummationspunkt 9 des Operationsverstärkers 3 praktisch ganz über die Eingangsimpedanz $Z_e$ abfliesst. Deshalb ist es bei hochohmigem $Z_e$ angezeigt, einen Kompensationsstrom $I_K$ besagtem Anschluss zuzuführen.

In Fig. 2 ist eine bevorzugte Variante des Messkreises von Fig. 1 dargestellt. Als Operationsverstärker 3 ist dabei der Operationsverstärker ICH 8500/A mit MOS-FET-Eingangs-Differentialstufe und Eingangs-Schutzdioden der Firma Intersil verwendet, mit einem spezifizierten maximalen Eingangsruhestrom von 0,01 pA. Als Eingangsfehlerstrom-Kompensationsmittel entsprechend der in Fig. 1 dargestellten Quelle für den Kompensationsstrom $I_K$ ist ein Potentiometer $P_{off}$ eingesetzt, zur Veränderung des Stromteilverhältnisses an der Differential-Eingangsstufe, an Anschlüsse 13 und 14 geschaltet, mit dem Mittelabgriff auf negative Speisespannung, wie dies für den Offset-Spannungsabgleich an diesem Verstärker vorgesehen ist. Der Ausgang 5 dieses Operationsverstärkers ist auf einen nichtinvertierenden PI-Regler geführt, z.B. in der schematisch bei 7 dargestellten Schaltungskonfiguration. Die Regelgrösse $U_x$ als Ausgangsspannung des Reglers 7, ist weiter über einen hochohmigen Unterbrecherschalter $S_u$ auf den Anschluss A für eine Gleichspannungsquelle 1, geführt, letztere über einen hochwertigen Kondensator $C_e$, als Eingangsimpedanz des Verstärkers 3, auf den Anschluss E. Dieser Anschluss E ist weiter über die Sekundärseite 15 eines Hochfrequenzübertragers 17 auf den Stromsummationspunkt 9 des Operationsverstärkers 3 geführt. Der Übertrager 17 ist primärseitig als frequenzbestimmendes Netzwerk an einem emittergekoppelten Oszillator 19 geschaltet, wozu z.B. der integrierte Oszillator MC 1648 der Firma Motorola eingesetzt ist, betrieben auf einer Frequenz von ca. 80 MHz. Als Rückkopplungsimpedanz $Z_K$ ist eine kleine hochwertige Kapazität $C_K$ eingesetzt, überbrückt durch ein hochohmiges Rücksetzrelais $R_x$. Bei entsprechender Auslegung des Frequenzganges des PI-Reglers, nach üblichen Gesichtspunkten der Regelungstechnik und bei Vorgabe einer Eingangskapazität $C_e$ von ca. 5 pF bei einem Leckwiderstand $R_e$ von ca. $10^{15}$ Ohm ist es, nachdem sich der Messkreis thermisch stabilisiert hat und bei gut stabilisierter Speisespannung möglich, den Eingangsstörstrom mit dem Potentiometer $P_{off}$ auf Werte kleiner als $10^{-16}$ A abzugleichen, was einer Spannungsdrift von weniger als 2 mV/sek entspricht. Der Unterbrecherschalter $S_u$ hat folgende Funktion:

Wird als auszumessende Quelle eine extrem hochohmige, praktisch kapazitive Quelle eingesetzt, so muss sichergestellt werden, dass vor Inbetriebnahme des Messregelkreises durch Öffnen des Rücksetzschalters $R_x$ nicht eine Aufladung der Quellen-Innen-Kapazität entsprechend $C_e$ erfolgt. Zu diesem Zweck wird vor Anschliessen der auszumessenden Quelle an den Anschlüssen A und E der Schalter $S_u$ geöffnet und stellt somit eine Kapazität dar, die wesentlich kleiner ist als die Kapazität der Quellen-Innenimpedanz, entsprechend $C_e$. Damit lädt die auszumessende Quelle vornehmlich die durch den Schalter $S_u$ gebildete Schalterkapazität auf. Danach kann der Messregelkreis durch Öffnen des Rücksetzschalters $R_x$ in Betrieb genommen werden, allerdings mit noch geringer, durch die kleine Kapazität des Schalters $S_u$ mitbestimmter Kreisverstärkung. Nach Schliessen des Unterbrecherschalters $S_u$ springt jedoch die Regelgrösse $U_x$ auf den Spannungswert der Spannungsquelle, entsprechend 1a von Fig. 2. Nach diesem Verfahren wurden Einstellgenauigkeiten der Regelgrössen $U_x$ auf die auszumessende Spannung entsprechend der Quelle 1a, von ca. 50‰ erzielt.

Der beschriebene Messkreis eignet sich nun ausgezeichnet für den Einsatz der nachfolgend beschriebenen Elektrode.

In Fig. 3a ist das Ersatzbild einer extrem hochohmigen resp. kapazitiven Spannungsquelle mit der idealen Spannungsquelle $U_o$ und der Innenka-pazität $C_i$ dargestellt. Zur Ausmessung einer elek-trochemischen Halbzellenspannung wird eine sol-che kapazitive Spannungsquelle, wie in Fig. 3a dargestellt, beispielsweise so realisiert: Die Halbzelle aus dem Metall Me und der Elektrolytlösung E1 sei auszumessen. Dann wird eine erfindungsgemässe Bezugselektrode eingesetzt, mit einer Isolationsschicht Js, die einerseits mit der Elektrolytlösung E1 kontaktiert wird und anderseits mit einer Leiterschicht L versehen ist. Die elektrischen Abgriffe der Ganzzelle für das Anschliessen in den Messkreis, an den Anschlüssen A und E von Fig. 2, werden einerseits am Metall Me, anderseits an der Leiterschicht L der Elektrode, beispielsweise ebenfalls aus Metall, angebracht. Die vornehmlich zwischen Metall und Elektrolytlö-sung sich bildende Kontaktspannung $U_o$ wird mit Hilfe der durch Isolationsschicht Js und die Leiter-schicht L gebildeten erfindungsgemässen Be-zugselektroden an einem Messkreis, wie beispielsweise in Fig. 2 dargestellt, messbar.

Wie in Fig. 3b dargestellt, kann mit dem, beispielsweise in Fig. 2 dargestellten, Messkreis auch die Kontaktspannung zwischen Isolatoren $Js_1$ und $Js_2$ von zwei erfindungsgemässen Elektro-den resp. die resultierende Kontaktspannungsdif-ferenz, beispielsweise zwischen den Isolatoren und einer Elektrolytlösung E1 gemessen werden.

Mit der erfindungsgemässen kapazitiven Elek-trode, z.B. $Me_1$, $Js_1$, A dürfte insbesondere die Dynamik des Aufbaus von Kontaktspannungen, beispielsweise zwischen Metallen und Elektrolytlösungen messbar werden, und die erfindungsgemässe kapazitive Elektrode dürfte gerade für die Analysetechnik eine äusserst einfache Bezugselektrode bilden.

## Patentansprüche

1. Elektrode zum Abgreifen einer Spannung einer Quelle mit flächenhaftem Abgriff, dadurch gekennzeichnet, dass sie aus einer Isolationsschicht ($Js$; $Js_1$, $Js_2$) besteht, die auf einer Seite eine Lei-terschicht ($Me_1$, $Me_2$) mit elektrischem Abgriff (E) aufweist, derart, dass bei Anlegen der freien Schichtseite an den flächenhaften Abgriff (E1) der Quelle, durch letzteren, die Isolationsschicht und die Leiterschicht eine zur Quelle seriegeschaltete Kapazität entsteht.

2. Anwendung der Elektrode nach Anspruch 1 zur Messung von DC- oder sich langsam ändernden Spannungen.

3. Anwendung der Elektrode nach Anspruch 1 zur Messung einer Kontaktspannung zwischen Isolatoren ($Js_1$, $Js_2$). (Fig. 3b)

4. Anwendung der Elektrode nach Anspruch 1 als Bezugselektrode in einer elektrochemischen Zelle mit einer ersten Materialphase (Me) und einer zweiten (E1), wobei die Spannung zwischen der ersten und zweiten Materialphase, der ersten Halbzelle, zu messen ist und die Isolationsschicht (Js) mit der einen der Phasen (E1), als zweite Halbzelle, in Kontakt steht.

## Claims

1. An electrode for tapping a voltage from a source with areatype tap characterised in that it consists of an insulating layer ($Js$; $Js_1$, $Js_2$), which, on one side, has a conductive layer ($Me_1$, $Me_2$) with electrical tap (E), such that when the free side of the layer is applied to the area-type tap (E1) of the source, a capactiy connected in series to the source is created by the area-type tap, the insulating layer and the conductive layer.

2. Use of the electrode according to claim 1 for measuring DC or slowly changing voltages.

3. Use of the electrode according to claim 1 for measuring a contact voltage between insulators ($Js_1$, $Js_2$). (Fig. 3b)

4. Use of the electrode according to claim 1 as reference electrode in an electro-chemical cell with a first material phase (Me) and a second (E1), whereby the voltage shall be measured between the first and second material phase, the first semi-cell, and whereby the insulating layer (Js) is in contact with one of the phases (E1) as the second semi-cell.

## Revendications

1. Electrode pour capter la tension d'une source présentant un contact plan de captage, caractérisée en ce qu'elle se compose d'une couche iso-lante ($Js$; $Js_1$, $Js_2$) qui comporte, sur l'une de ses faces, une couche conductrice ($Me_1$; $Me_2$) munie d'un contact électrique (E), de telle façon que lorsque l'on applique la face libre de cette couche contre la zone de contact plane (E1) de la source, ces dernières, la couche isolante et la couche conductrice, forment une capacité branchée en série avec la source.

2. Utilisation de l'électrode selon la revendication 1, pour la mesure de tensions continues ou de tensions à variation lente.

3. Utilisation de l'électrode selon la revendication 1, pour la mesure d'une tension de contact entre des isolateurs ($Js_1$, $Js_2$) (fig. 3b).

4. Utilisation de l'électrode selon la revendication 1, comme électrode de référence dans une cellule électrochimique comportant une première phase de matière (Me) et une deuxième phase de matière (E1), la tension à mesurer étant la tension entre la première et la deuxième phases, qui forment la première demi-cellule, et la couche isolante (Js) étant placée en contact avec l'une des phases (E1) pour former la deuxième demi-cellule.

# Fig. 1

# Fig. 2

# Fig. 3a

# Fig. 3b